(19) Europäisches Patentamt
European Patent Office
Office européen des brevets

(11) **EP 2 413 224 B1**

(12) **EUROPEAN PATENT SPECIFICATION**

(45) Date of publication and mention
of the grant of the patent:
**17.08.2016 Bulletin 2016/33**

(51) Int Cl.:
**G06F 3/044** *(2006.01)*   **G06F 3/041** *(2006.01)*
**H03K 17/96** *(2006.01)*

(21) Application number: **11175801.7**

(22) Date of filing: **28.07.2011**

(54) **Compensation for capacitance change in touch sensing device**

Kapazitätsänderungsausgleich in berührungsempfindlichen Vorrichtungen

Compensation pour changement de capacité dans un dispositif de détection tactile

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.07.2010 US 848032**

(43) Date of publication of application:
**01.02.2012 Bulletin 2012/05**

(73) Proprietor: **APPLE INC.**
**Cupertino, CA 95014 (US)**

(72) Inventors:
• **Grunthaner, Martin Paul**
**Cupertino, CA, 95014 (US)**

• **Harley, Jonah A.**
**Cupertino, CA, 95014 (US)**
• **Mullens, Christopher Tenzin**
**Cupertino, CA, 94014 (US)**

(74) Representative: **Lang, Johannes**
**Bardehle Pagenberg Partnerschaft mbB**
**Patentanwälte, Rechtsanwälte**
**Prinzregentenplatz 7**
**81675 München (DE)**

(56) References cited:
**WO-A1-2009/000289     US-A1- 2008 047 764**
**US-A1- 2010 066 391**

## Description

### Field

This relates generally to touch sensing devices and, more particularly, to compensation for undesirable capacitance changes in a touch sensing device.

### Background

Touch sensitive devices have become quite popular as input devices to computing systems because of their ease and versatility of operation as well as their declining price. A touch sensitive device can include a touch sensor panel, which can be a clear panel with a touch sensitive surface, and a display device such as a liquid crystal display (LCD) that can be positioned partially or fully behind the panel so that the touch sensitive surface can cover at least a portion of the viewable area of the display device. The touch sensitive device can allow a user to perform various functions by touching the touch sensor panel using a finger, stylus or other object at a location often dictated by a user interface (UI) being displayed by the display device. In general, the touch sensitive device can recognize a touch event and the position of the touch event on the touch sensor panel, and the computing system can then interpret the touch event in accordance with the display appearing at the time of the touch event, and thereafter can perform one or more actions based on the touch event.

At times, environmental conditions and device operations can adversely affect the touch sensitive device's ability to recognize a touch event. For example, capacitance changes due to a change in the device temperature caused by either an ambient temperature change or heat from device components can mask a real touch event or erroneously indicate a false touch event. Because a touch sensitive device cannot avoid generating some heat during operation and cannot control the outside environment, it can be difficult to prevent errors in touch event recognition.

Document US 2008/947764 A1 discloses method and apparatus for detecting an environmental effect and a presence of a conductive object on a touch-sensing device without using a dedicated environmental effect sensor, and compensating for the environmental effect on the detection of the conductive object. The disclosed method includes detecting an environmental effect on a touch-sensing device using a touch sensor, detecting a presence of a conductive object, and compensating for the environmental effect on the detection of the conductive object. The document furthermore discloses a capacitive sensor, which is coupled to a capacitive switch array via a bus including multiple pins. The capacitive sensor and the pins may be shielded from the user, wherein one of the pins may be uncoupled or coupled to a conductive element, such as a conductive trace or the like, and the conductive element is shielded from the user so it does not respond to the presence of a conductive object that represents user interaction.

### Summary

This relates to compensation for undesirable capacitance changes in a touch sensing device. The capacitance changes, which can be caused by environmental changes and/or device operating changes and not by a touch, can mask an actual touch at the device and/or erroneously indicate a false touch. To compensate for such capacitance changes, the touch sensing device can include one or more reference conductive traces decoupled from touch sensors of the device to measure non-touch capacitance. The touch sensing device can then adjust a touch signal with the non-touch capacitance measurement to substantially reduce or eliminate the non-touch capacitance from the signal. In one example, the reference trace can be disposed on a flexible circuit of the touch sensing device parallel to a conductive trace that transmits the touch signal from a touch sensor panel of the device, thereby giving an indication of the non-touch capacitance introduced by the conductive trace. In another example, the reference trace can be extended onto the touch sensor panel parallel to a touch sensor trace that transmits the touch signal from a touch sensor to the conductive trace on the flexible circuit, thereby giving an indication of the non-touch capacitances introduced by the touch sensor trace and the conductive trace. In still another example, the reference trace can be extended further onto the touch sensor panel to couple to a conductive element on the panel that measures non-touch capacitance of the touch sensor, thereby giving an indication of the non-touch capacitances introduced by the touch sensor, the touch sensor trace, and the conductive trace. In another example, the reference trace coupled to a touch controller of the touch sensing device (to which the reference trace transmits the non-touch capacitances of the touch sensor, the touch sensor trace, and/or the conductive trace) can give an indication of the non-touch capacitance introduced by various components on the touch controller. Compensation for undesirable capacitance changes in the touch sensing device can advantageously provide a more accurate and reliable touch signal regardless of the conditions and circumstances in which the device operates.

**Brief Description of the Drawings**

FIG. 1 illustrates an exemplary touch sensing device that can compensate for capacitance changes according to various embodiments.

FIG. 2 illustrates another exemplary touch sensing device that can compensate for capacitance changes according to various embodiments.

FIG. 3 illustrates another exemplary touch sensing device that can compensate for capacitance changes according to various embodiments.

FIG. 4 illustrates another exemplary touch sensing device that can compensate for capacitance changes according to various embodiments.

FIG. 5 illustrates an exemplary method to compensate for capacitance changes in a touch sensing device according to various embodiments.

FIG. 6 illustrates an exemplary computing system that can compensate for capacitance changes according to various embodiments.

FIG. 7 illustrates an exemplary mobile telephone that can compensate for capacitance changes according to various embodiments.

FIG. 8 illustrates an exemplary digital media player that can compensate for capacitance changes according to various embodiments.

FIG. 9 illustrates an exemplary personal computer that can compensate for capacitance changes according to various embodiments.

**Detailed Description**

In the following description of various embodiments, reference is made to the accompanying drawings which form a part hereof, and in which it is shown by way of illustration specific embodiments which can be practiced. It is to be understood that other embodiments can be used and structural changes can be made without departing from the scope of the various embodiments.

This relates to compensation for undesirable capacitance changes in a touch sensing device, where the capacitance changes are not indicative of a touch at the device, but of environmental changes or device operating changes. Environmental changes can include ambient temperature, humidity, and barometric pressure changes. Device operating changes can include start-up, shutdown, and prolonged operation of device components. To compensate for such capacitance changes, the touch sensing device can include one or more reference conductive traces decoupled from touch sensors of the device to measure non-touch capacitances in the device. The touch sensing device can then adjust a touch signal from the touch sensors using the non-touch capacitance measurements to substantially reduce or eliminate the non-touch capacitances from the signal.

The touch sensing device can include a touch sensor panel having one or more touch sensors for sensing a touch at the panel, a flexible circuit for transmitting the sensed touch signal from the panel, and a touch controller for receiving and processing the transmitted signal. In one embodiment, the reference trace can be disposed on the flexible circuit parallel to a conductive trace that transmits the touch signal from the touch sensor panel to the touch controller, thereby giving an indication of the non-touch capacitance introduced by the conductive trace. One end of the reference trace can be coupled to the touch controller to transmit the non-touch capacitance thereto. The other end of the reference trace can be free on the flexible circuit.

In another embodiment, the reference trace can be extended onto the touch sensor panel parallel to a touch sensor trace that transmits the touch signal from a touch sensor to the conductive trace on the flexible circuit, thereby giving an indication of the non-touch capacitances introduced by the touch sensor trace and the conductive trace. One end of the reference trace can be coupled to the touch controller to transmit the non-touch capacitances thereto. The other end of the reference trace can be free on the touch sensor panel.

In still another embodiment, the reference trace can be extended further onto the touch sensor panel to couple to a conductive element on the panel that measures non-touch capacitance of the touch sensor, thereby giving an indication of the non-touch capacitances introduced by the touch sensor, the touch sensor trace, and the conductive trace. One end of the reference trace can bye coupled to the touch controller to transmit the non-touch capacitances thereto. The other end of the reference trace can be coupled to the conductive element on the panel.

In another embodiment, the reference trace coupled to the touch controller can give an indication of the non-touch capacitances introduced by various components on the touch controller along with non-touch capacitances of the conductive trace, the touch sensor trace, and/or the touch sensor.

Compensating for undesirable capacitance changes can advantageously realize more accurate and reliable touch measurements regardless of the conditions and circumstances in which the touch sensing device operates.

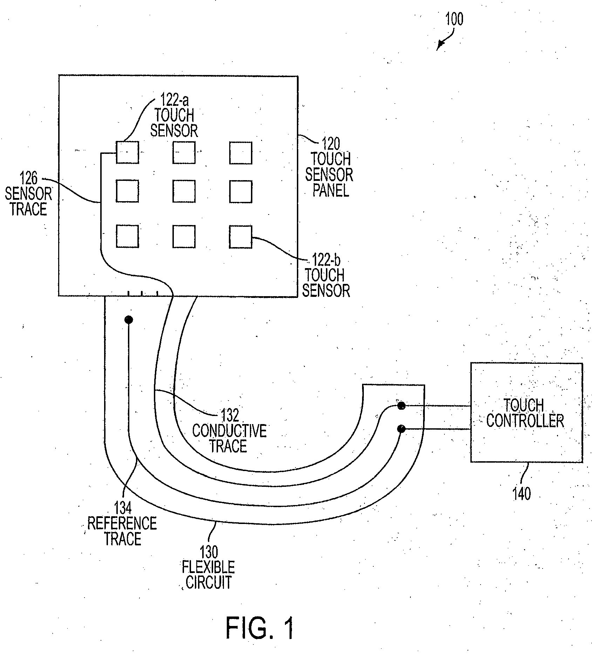

FIG. 1 illustrates an exemplary touch sensing device that can compensate for undesirable capacitance changes according to various embodiments. In the example of FIG. 1, touch sensing device 100 can include touch sensor panel 120, flexible circuit 130, and touch controller 140 to sense a touch or near-touch (hover) at the device. As an object approaches the panel 120, a small capacitance can form between the object and capacitive touch sensors 122 proximate to the object. Touch signals indicating changes in capacitance caused by this small capacitance and the position of the touch sensor 122-a sensing the object can be transmitted along sensor trace 126 through the flexible circuit 130 to the touch controller 140 for processing. The capacitive touch sensors 122 can be based on self capacitance.

In a self capacitance sensor panel, the self capacitance of a touch sensor can be measured relative to some reference, e.g., ground. The touch sensors 122 can be spatially separated electrodes. The touch sensors 122 can be indium-tin-oxide (ITO) or any suitable conductive material. Each electrode can define a touch sensor 122. The electrodes can be coupled to driving circuitry via conductive traces (not shown) and to sensing circuitry, e.g., the touch controller 140, via sensor traces 126. The sensor traces 126 can be silver, copper, or any suitable conductive material. Each touch sensor electrode 122 can have a sensor trace 126. Touches, near-touches (hovers), and gestures can be detected at the panel 120 by measuring changes in the capacitance of the electrode forming the touch sensor 122.

During operation, the total capacitance along a sensing path can be measured from the touch sensors 122 to the touch controller 140. Under normal conditions, in some embodiments, the capacitance of the touch sensors 122 can be approximately 12 picofarads (pF), the sensor traces 126 approximately 2 pF, the conductive traces 132 approximately 8-10 pF, and various components at the touch controller 140 about 2 pF. In some embodiments, a touch at the touch sensors 122 can increase the total capacitance by 0.3 to 1.5 pF. Upon measuring this increase, the touch controller 140 can deduce that there has been a touch at the panel 120 and perform further processing accordingly.

However, when the device experiences environmental changes or device operating changes that cause the device temperature, for example, to increase, the dielectric constants and/or the geometry of the device materials can change, thereby increasing the capacitances of proximate conductive components. In some instances, the capacitance change due to environmental changes or device operating changes can exceed the capacitance change due to a touch. Some materials can be more sensitive to environmental or device changes than others and therefore more prone to change their dielectric constants. For example, the touch sensor panel substrate can be glass or like substrates, which can be less sensitive to changes; whereas the flexible circuit substrate can be polyimide or like flexible polymers, which can be more sensitive to changes. In some instances, the flexible circuit's conductive components can contribute a majority of the increase in capacitance when there are environmental or device operating changes. Therefore, eliminating or reducing the contributions from at least the flexible circuit's components can substantially reduce or eliminate the effects of the changes.

To do so, referring again to FIG. 1, reference trace 134 can be disposed on the flexible circuit 130 parallel to the conductive trace 132, but decoupled from the touch sensor 122-a. As such, the reference trace 134 can provide the same or a similar capacitance as the conductive trace 132. When there is an environmental or device operating change that causes a temperature increase, for example, in the flexible circuit 130, the capacitance of the reference trace 134 and the conductive trace 132 can increase or otherwise change in a similar manner. The amount of the increase may not be readily apparent on the conductive trace 132 because the trace may also include a touch signal. However, since the reference trace 134 is decoupled from the touch sensor 122-a, the reference trace can have just the capacitance measurement. Therefore, the amount of the capacitance increase can be measured from the reference trace 134 and applied to the transmitted touch signal to substantially reduce or eliminate the conductive trace's capacitance increase from the signal. This can provide a more accurate touch measurement despite the undesirable capacitance change.

Similarly, a hover measurement can be adjusted by applying the capacitance measurement from the reference trace 134 to the transmitted hover signal to substantially reduce or eliminate the conductive trace's capacitance increase from the signal. A touch and hover measurement can be similarly adjusted to substantially reduce or eliminate the conductive trace's capacitance increase from the transmitted touch and hover signal.

In alternate embodiments, one or more additional reference traces can be disposed on the flexible circuit parallel to the conductive trace, but decoupled from the touch sensors. Capacitances can vary somewhat by location on the flexible circuit according to the number of neighboring traces, which can parasitically couple with a trace. As such, a reference trace can be placed in the middle of the flexible circuit, while another reference trace can be placed at an edge of the flexible circuit. The appropriate edge and/or center reference trace can then be used to correspondingly compensate neighboring conductive traces that are either edge or center races. Alternatively, an average capacitance from the reference traces can be calculated and applied to the touch measurement to compensate for the undesirable capacitance changes. Or the capacitance(s) of the reference trace(s) closest to the conductive trace can be applied to the touch measurement.

It is to be understood that the touch sensor arrangement is not limited to that illustrated herein, but can be a radial, circular, diamond, diagonal, and like arrangements according to the needs of the device.

It is to be further understood that the touch sensing device is not limited to self capacitance, but can be based on mutual capacitance as well. In a mutual capacitance sensor panel, the mutual capacitance of a touch sensor can be measured between two conductors. The touch sensors can be formed by the crossing of patterned conductors forming spatially separated drive and sense lines, or by placing the drive and sense lines adjacent to each other. Driving circuitry can be coupled to the drive lines and sensing circuitry can be coupled to the sensing lines. Touches, near-touches (hovers), and gestures can be detected at the panel by measuring changes in the capacitance between the drive and sense lines associated with the touch sensor.

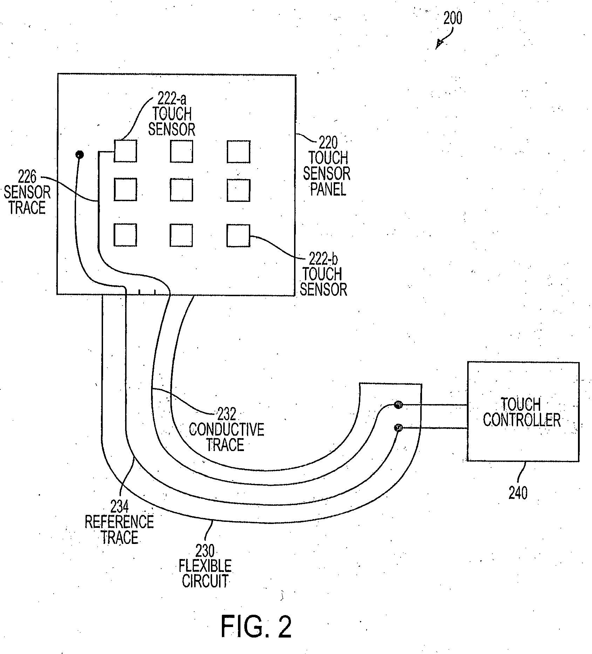

FIG. 2 illustrates another exemplary touch sensing device that can compensate for undesirable capacitance changes according to various embodiments. The device of FIG. 2 is the same as the device of FIG. 1 except for the following addition. In the example of FIG. 2, reference trace 234 can extend onto touch sensor panel 220 to be proximate to sensor trace 226. As a result, the reference trace 234 can have a same or similar capacitance as the sensor trace 226 in addition to having a same or similar capacitance as the conductive trace 232. While the flexible circuit 230 can contribute to an undesirable capacitance change, the touch sensor panel 220 can also contribute, such that eliminating or substantially reducing the effects of the panel can likewise be helpful. When there is an environmental or device operating change that causes a temperature increase, for example, in touch sensor panel 120, the capacitance of the reference trace 134 and the sensor trace 126 can increase. The amount of the increase may not be readily apparent on the sensor trace 226 because the trace may also include a touch signal. However, since the reference trace 234 is decoupled from the touch sensor 222-a, the reference trace can just have the capacitance measurement. The amount of the increase can therefore be measured from the reference trace 234 and applied to the transmitted touch signal to substantially reduce or eliminate the sensor trace's capacitance increase from the signal. As described in FIG. 1, the amount of the increase in the conductive trace's 232 capacitance can also be measured from the reference trace 234 and applied to the transmitted touch signal to substantially reduce or eliminate the conductive trace's capacitance increase from the signal. Application of the reference trace capacitance measurement can provide a more accurate touch measurement despite the undesirable capacitance changes.

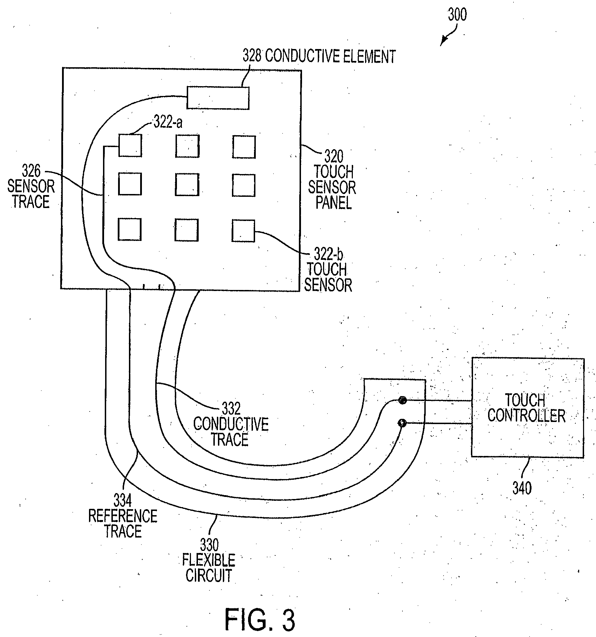

FIG. 3 illustrates another exemplary touch sensing device that can compensate for capacitance changes according to various embodiments. The device of FIG. 3 is the same as the device of FIG. 2 except for the following addition. In the example of FIG. 3, reference trace 334 can extend further onto touch sensor panel 320 to be coupled to conductive element 328. The conductive element 328 can be ITO similar to the touch sensors 322. As a result, the conductive element 328 can have a same or similar capacitance as the touch sensors 322. When there is an environmental or device operating change that cause a temperature increase, for example, in the touch sensor panel 320, the capacitance of the conductive element 328 and the touch sensors 322 can increase or otherwise change in a similar manner. The amount of the increase may not be readily apparent on the touch sensors 322 because the sensors may also include a touch signal. However, since the conductive element 328 is not coupled to the touch sensor 322-a, the conductive element can have just the capacitance measurement associated with an environmental or device operating change. The amount of the increase can therefore be measured from the conductive element 328 and therefore the reference trace 324 and applied to the transmitted touch signal to substantially reduce or eliminate the touch sensors' non-touch capacitance increase from the signal. As described in FIG. 2, the amount of increase in the sensor trace's 326 and the conductive trace's 332 capacitances can also be measured from the reference trace 324 and applied to the transmitted touch signal to substantially reduce or eliminate the sensor trace's and the conductive trace's capacitance increases from the signal. Application of the reference trace capacitance measurement can provide a more accurate touch measurement despite the undesirable capacitance changes.

In an alternate embodiment, the reference trace can couple to the conductive element without following the sensor trace such that the reference trace can provide capacitance increases of the touch sensor on the touch sensor panel and the conductive traces on the flexible circuit. This embodiment may be useful when the sensor traces capacitance increases are not very significant, when space is limited on the panel, or for any suitable reason.

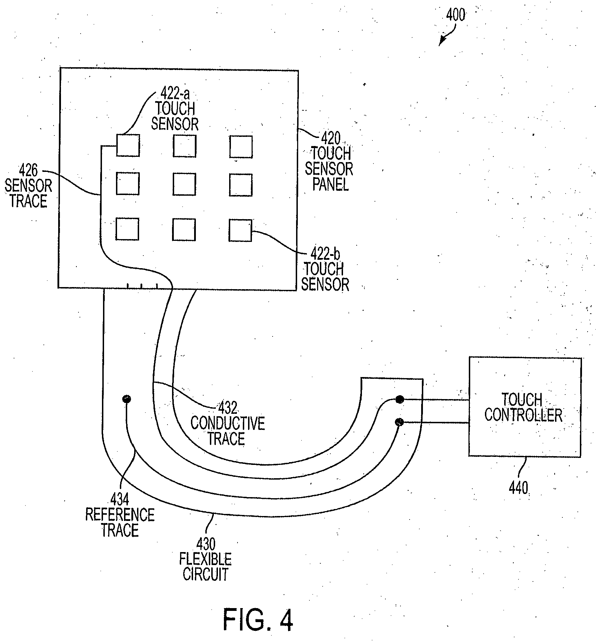

FIG. 4 illustrates another exemplary touch sensing device that can compensate for undesirable capacitance changes according to various embodiments. The device of FIG. 4 is the same as the device of FIG. 1 except for the following. In the example of FIG. 4, reference trace 434 can extend only part of the length of conductive trace 432. This arrangement can be useful when the flexible circuit 430 is space-limited. Similar to reference trace 134 of FIG. 1, the reference trace 434 of FIG. 4 can transmit a capacitance measurement indicative of a capacitance change in the conductive trace 432 caused by environmental or device operating changes affecting the flexible circuit 430. The amount of the increase can therefore be measured from the reference trace 434 and applied to the transmitted touch signal to substantially reduce or eliminate the conductive trace's 432 capacitance increase from the signal. The amount of capacitance applied to the transmitted touch signal can be scaled either proportionally or otherwise to more closely approximate the conductive trace's 432 capacitance with the reduced reference trace 434. Application of the reference trace capacitance measurement can provide a more accurate touch measurement despite the undesirable capacitance change.

As illustrated in FIGs. 1 through 4, the reference trace can be coupled to the touch controller to transmit capacitance measurements thereto. Various components of the touch controller can also introduce undesirable capacitance changes into the touch sensing device. Accordingly, the reference trace can measure capacitance changes of these components, which can be used along with the measurements associated with the conductive traces on the flexible circuit, the sensor traces on the touch sensor panel, and/or the conductive elements on the touch sensor panel to adjust touch measurements.

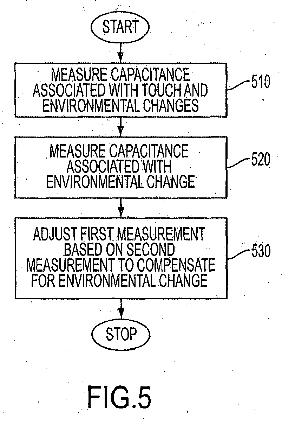

FIG. 5 illustrates an exemplary method to compensate for undesirable capacitance changes in a touch sensing device according to various embodiments. In the example of FIG. 5, a touch controller can measure a touch signal from a touch sensor that is transmitted to the controller through a conductive trace on a flexible circuit coupled to the touch sensor (510). The touch signal can include a first capacitance indicative of a touch at the touch sensor and a second capacitance indicative of an environmental or device operating change affecting the flexible circuit. The touch controller can measure the second capacitance from a reference trace on the flexible circuit parallel and proximate to the conductive trace, but decoupled from the touch sensor (520). The touch controller can then adjust the touch measurement based on the second capacitance measurement to compensate the touch measurement for the undesirable capacitance change (530). The result can be a more accurate touch measurement despite the capacitance, change.

In alternate embodiments, the touch controller can measure the second capacitance from a reference trace on the touch sensor panel and the flexible circuit, where a portion of the reference trace is parallel and proximate to a sensor trace on the panel and another portion of the reference trace is parallel and proximate to a conductive trace on the flexible circuit (520).

In alternate embodiments, the touch controller can measure the second capacitance from a reference trace coupled to a conductive element on the touch sensor panel in addition to being parallel and proximate to the sensor trace on the panel and/or the conductive trace on the flexible circuit (520).

The method of FIG. 5 can be implemented according to various embodiments. In one embodiment, the method can account for a change in measured touch sensor capacitance by measuring the change in the reference trace on the flexible circuit and scaling the result accordingly.

This method can start with the assumption that the untouched sensor capacitance is made up of the flexible circuit substrate capacitance, $C_{flex}$, plus the touch sensor panel substrate capacitance, $C_{panel}$, and that the flexible circuit capacitance is fully known from measurements of the reference trace on the flexible circuit.

$$C_{sensor} = C_{panel} + C_{flex}. \qquad (1)$$

In order to measure capacitance changes, baseline values can be known for the flexible circuit (the reference trace) and overall touch sensor (panel + flexible circuit). These values can be obtained anytime when the sensor is untouched, such as during a factory calibration. Considering the example of temperature compensation, suppose the calibration measurement was taken at temperature T1 and the current measurement is at temperature T2. As such, the change in capacitance for the flexible circuit can be

$$\Delta C_{flex} = C_{flex\_T2} - C_{flex\_T1} \qquad (2)$$

and for the sensor,

$$\Delta C_{sensor} = C_{sensor\_T2} - C_{sensor\_T1}. \qquad (3)$$

Using Equations (1), (2), and (3), the change in capacitance for the panel substrate can be

$$\Delta C_{panel} = C_{panel\_T2} - C_{panel\_T1}. \qquad (4)$$

The panel substrate capacitance can track the flexible circuit capacitance and can be scaled according to the ratio of the capacitances (i.e., the percent capacitance change can track) and can additionally have a scaling factor $\alpha$ if the temperature coefficients of the panel substrate and the flexible circuit are different. This can be expressed as

$$\frac{\Delta C_{panel}}{C_{panel\_T1}} = \alpha \, \frac{\Delta C_{flex}}{C_{flex\_T1}} . \qquad (5)$$

If the original values of $C_{flex\_T1}$ and $C_{sensor\_T1}$ are known at temperature T1, and the change of the flexible circuit capacitance is known from the reference trace, then a sensor measurement at temperature T2 can be scaled back to the reference temperature, T1, using the formula

$$C_{sensor\_comp} = C_{sensor\_T2} - \Delta C_{flex} - \Delta C_{panel} \qquad (6)$$

where $\Delta C_{panel}$ can be estimated from Equation (5) and the measured $\Delta C_{flex}$. Substittiting from Equation (5) into Equation (6), the compensated sensor measurement can be expressed as

$$C_{sensor\_comp} = C_{sensor\_T2} - \Delta C_{flex} - \alpha \, \frac{\Delta C_{flex}}{C_{flex\_T1}} C_{panel\_T1} . \qquad (7)$$

Here, the change in flexible circuit capacitance and the change in panel substrate capacitance can be subtracted from the sensor measurement to provide the compensated sensor measurement. The scaling factor $\alpha$ can typically vary from 0.5 to 2, but can span an even larger range if the panel substrate and the flexible circuit are vastly different in temperature sensitivity, one being more temperature sensitive than then other.

If the reference trace is shorter than the conductive traces, as shown in FIG. 4, the capacitance change can first be scaled by the length of the conductive trace 432 to the reference trace 434 prior to applying the above method.

An alternative method can simply assume that the overall sensor measurement tracks proportionally with the flexible circuit capacitance, according to

$$C_{sensor\_comp} = \frac{C_{flex\_T2}}{C_{flex\_T1}} C_{sensor\_T1} \qquad (8)$$

Here, it can be assumed that the panel substrate temperature coefficient matches the flexible circuit temperature coefficient and, therefore, has additional error taken into account.

Although these example methods address temperature compensation, they can apply equally well to other environmental changes, e.g., humidity and pressure, and to design operating changes.

It is to be understood that the method of FIG. 5 is not limited to these embodiments, but can include other methods suitable for compensating a touch measurement for environmental or device operating changes.

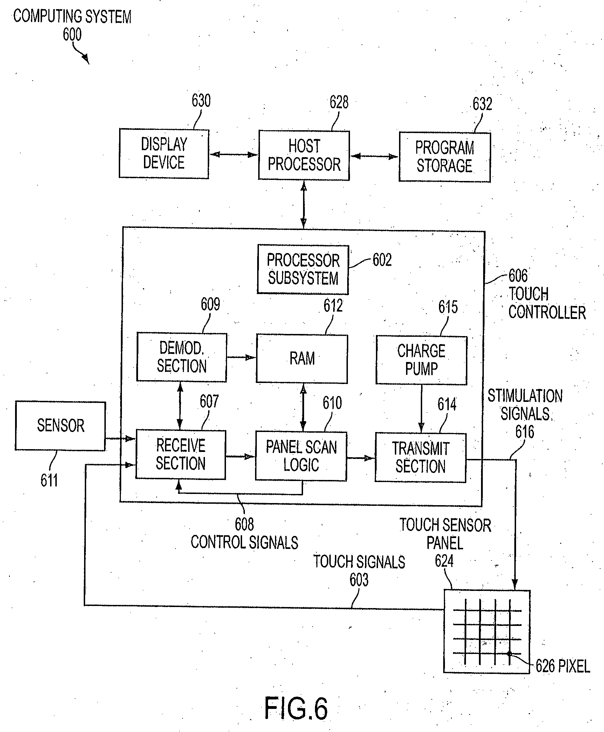

FIG. 6 illustrates an exemplary computing system 600 that can compensate for an undesirable capacitance change in a touch sensing device according to various embodiments described herein. In the example of FIG. 6, computing system 600 can include touch controller 606. The touch controller 606 can be a single application specific integrated circuit (ASIC) that can include one or more processor subsystems 602, which can include one or more main processors, such as ARM968 processors or other processors with similar functionality and capabilities. However, in other embodiments, the processor functionality can be implemented instead by dedicated logic, such as a state machine. The processor subsystems 602 can also include peripherals (not shown) such as random access memory (RAM) or other types of memory or storage, watchdog timers and the like. The touch controller 606 can also include receive section 607 for receiving signals, such as touch signals 603 of one or more sense channels (not shown), other signals from other sensors such as sensor 611, etc. The touch controller 606 can also include demodulation section 609 such as a multistage vector demodulation engine, panel scan logic 610, and transmit section 614 for transmitting stimulation signals 616 to touch-sensor panel 624 to drive the panel. The panel scan logic 610 can access RAM 612, autonomously read data from the sense channels, and provide control for the sense channels. In addition, the panel scan logic 610 can control the transmit section 614 to generate the stimulation signals 616 at various frequencies and phases that can be selectively applied to rows of the touch sensor panel 624.

The touch controller 606 can also include charge pump 615, which can be used to generate the supply voltage for the transmit section 614. The stimulation signals 616 can have amplitudes higher than the maximum voltage by cascading two charge store devices, e.g., capacitors, together to form the charge pump 615. Therefore, the stimulus voltage can be higher (e.g., 6V) than the voltage level a single capacitor can handle (e.g., 3.6 V). Although FIG. 6 shows the charge pump 615 separate from the transmit section 614, the charge pump can be part of the transmit section.

Touch sensor panel 624 can include a capacitive sensing medium having electrodes for detecting a touch at the panel. The electrodes can be formed from a transparent conductive medium such as Indium Tin Oxide (ITO) or Antimony Tin Oxide (ATO), although other transparent and non-transparent materials such as copper can also be used. Each electrode can represent a capacitive sensing node and can be viewed as picture element (pixel) 626, which can be particularly useful when the touch sensor panel 624 is viewed as capturing an "image" of touch. (In other words, after the touch controller 606 has determined whether a touch event has been detected at each touch sensor in the touch sensor panel, the pattern of touch sensors in the panel at which a touch event occurred can be viewed as an "image" of touch (e.g. a pattern of fingers touching the panel).)

Computing system 600 can also include host processor 628 for receiving outputs from the processor subsystems 602 and performing actions based on the outputs that can include, but are not limited to, moving an object such as a cursor or pointer, scrolling or panning, adjusting control settings, opening a file or document, viewing a menu, making a selection, executing instructions, operating a peripheral device coupled to the host device, answering a telephone call, placing a telephone call, terminating a telephone call, changing the volume or audio settings, storing information related to telephone communications such as addresses, frequently dialed numbers, received calls, missed calls, logging onto a computer or a computer network, permitting authorized individuals access to restricted areas of the computer or computer network, loading a user profile associated with a user's preferred arrangement of the computer desktop, permitting access to web content, launching a particular program, encrypting or decoding a message, and/or the like. The host processor 628 can also perform additional functions that may not be related to panel processing, and can be coupled to program storage 632 and display device 630 such as an LCD display for providing a UI to a user of the device. In some embodiments, the host processor 628 can be a separate component from the touch controller 606, as shown. In other embodiments, the host processor 628 can be included as part of the touch controller 606. In still other embodiments, the functions of the host processor 628 can be performed by the processor subsystem 602 and/or distributed among other components of the touch controller 606. The display device 630 together with the touch sensors panel 624, when located partially or entirely under the touch sensor panel or when integrated with the touch sensor panel, can form a touch sensitive device such as a touch screen.

Compensation for a capacitance change can be determined by the processor in subsystem 602, the host processor 628, dedicated logic such as a state machine, or any combination thereof according to various embodiments.

Note that one or more of the functions described above can be performed, for example, by firmware stored in memory (e.g., one of the peripherals) and executed by the processor subsystem 602, or stored in the program storage 632 and executed by the host processor 628. The firmware can also be stored and/or transported within any computer readable storage medium for use by or in connection with an instruction execution system, apparatus, or device, such as a computer-based system, processor-containing system, or other system that can fetch the instructions from the instruction execution system, apparatus, or device and execute the instructions. In the context of this document, a "computer readable storage medium" can be any medium that can contain or store the program for use by or in connection with the instruction execution system, apparatus, or device. The computer readable storage medium can include, but is not limited to, an electronic, magnetic, optical, electromagnetic, infrared, or semiconductor system, apparatus or device, a portable computer diskette (magnetic), a random access memory (RAM) (magnetic), a read-only memory (ROM) (magnetic), an erasable programmable read-only memory (EPROM) (magnetic), a portable optical disc such a CD, CD-R, CD-RW, DVD, DVD-R, or DVD-RW, or flash memory such as compact flash cards, secured digital cards, USB memory devices, memory sticks, and the like.

The firmware can also be propagated within any transport medium for use by or in connection with an instruction execution system, apparatus, or device, such as a computer-based system, processor-containing system, or other system that can fetch the instructions from the instruction execution system, apparatus, or device and execute the instructions. In the context of this document, a "transport medium" can be any medium that can communicate, propagate or transport the program for use by or in connection with the instruction execution system, apparatus, or device. The transport medium can include, but is not limited to, an electronic, magnetic, optical, electromagnetic or infrared wired or wireless propagation medium.

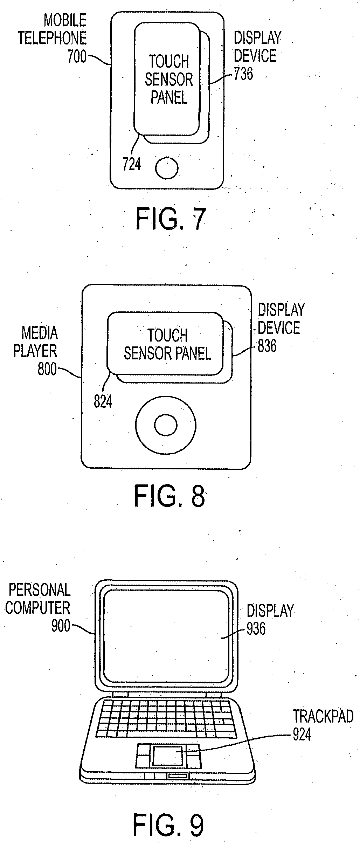

FIG. 7 illustrates an exemplary mobile telephone 700 that can include a display 736 and a touch sensor panel 724 that can compensate for capacitance changes according to various embodiments.

FIG. 8 illustrates an exemplary digital media player 800 that can include a display 836 and a touch sensor panel 824 that can compensate for capacitance changes according to various embodiments.

FIG. 9 illustrates an exemplary personal computer 900 that can include a touch sensitive display 936 and a touch sensor panel (trackpad) 924, where the touch sensitive display and the trackpad can compensate for capacitance changes according to various embodiments.

The mobile telephone, media player, and personal computer of FIGs. 7 through 9 can advantageously adapt to various operating conditions to provide more accurate touch sensing with a touch sensor panel that can compensate for capacitance changes according to various embodiments.

Although embodiments describe touch sensors, it is to be understood that proximity and other types of sensors can also be used. It is to be further understood that the touch sensing device according to various embodiments can be used to compensate hover measurements, combined touch and hover measurements, and the like for undesirable capacitance changes.

Accordingly, in view of the above, some embodiments of the disclosure are directed to a circuit comprising: a first substrate having a sensor thereon, the first substrate being sensitive to a state change in the circuit; a second substrate having at least two conductive traces thereon, the second substrate being sensitive to the state change in the circuit, a first of the conductive traces being associated with the sensor to transmit a signal from the sensor and a second of the conductive traces being disassociated from the sensor; and logic for determining from the second of the conductive traces a capacitance effect of the state change at the second substrate and for reducing the determined capacitance effect in the transmitted signal. In other embodiments, the first substrate is glass. In other embodiments, the second substrate is a flexible polymer. In other embodiments, the first and second substrates can have different sensitivities to the state change.

Some embodiments of the disclosure are directed to a touch sensing device comprising: multiple touch sensors disposed on a substrate to sense a touch at the device; a flexible circuit coupled to the touch sensors to transmit touch signals from the touch sensors indicative of the sensed touch, the flexible circuit including a first conductive trace to transmit the touch signals and a second conductive trace to measure an effect of an environmental change on the device; and a sensing circuit coupled to the flexible circuit to process the transmitted touch signals, including compensating the transmitted touch signals for the measured effect of the environmental change, wherein at least one of the substrate, the flexible circuit, or the sensing circuit is sensitive to the environmental change. In other embodiments, the sensors are self capacitance sensors. In other embodiments, the sensors are mutual capacitance sensors.

Although embodiments have been fully described with reference to the accompanying drawings, it is to be noted that various changes and modifications will become apparent to those skilled in the art. Such changes and modifications are to be understood as being included within the scope of the various embodiments as defined by the appended claims.

**Claims**

1. A touch sensing device (100; 200; 300; 400) comprising:

   at least one capacitive sensor (122a, 122b; 222a, 222b; 322a, 322b; 422a, 422b) disposed on a first substrate (120; 220; 320; 420) for sensing a touch at the sensor;
   a first conductive trace (126, 132; 226, 232; 326, 332; 426, 432) disposed on the first substrate (120; 220; 320; 420) and a second substrate (230; 230; 330; 430) and coupled to the sensor for transmitting a touch capacitance measurement indicative of the touch;
   a second conductive trace (134; 234; 334; 434) disposed on both the first and the second substrate or on the second substrate, decoupled from the sensor, parasitically coupling to and parallel and proximate to the first conductive trace on both the first and the second substrate or the second substrate (230; 230; 330; 430),

   the second conductive trace (134; 234; 334; 434) for transmitting a reference capacitance measurement indicative of a non-touch capacitance change so as to compensate for the non-touch capacitance change during transmission of the capacitance measurement,
   the non-touch capacitance change being associated with at least one of the first substrate (120; 220; 320; 420) or the second substrate (230; 230; 330; 430) and the first conductive trace (126, 132; 226, 232; 326, 332; 426, 432).

2. The device of claim 1, further comprising at least a third conductive trace disposed on the second substrate (230; 230; 330; 430), decoupled from the sensor, and parallel and proximate to the first conductive trace on the second substrate (230; 230; 330; 430), the third conductive trace for transmitting another reference capacitance measurement indicative of a further non-touch capacitance change so as to compensate for the further non-touch capacitance change during transmission of the touch capacitance measurement, wherein the second conductive trace (134; 234; 334; 434) is placed in the middle of the second substrate (230; 230; 330; 430), and the third conductive trace is placed at an edge of the second substrate (230; 230; 330; 430).

3. The device of claim 1, wherein the second substrate (230; 230; 330; 430) comprises a flexible circuit having the first (132; 232; 332; 432) and second conductive traces (134; 234; 334; 434) disposed thereon, wherein the non-touch capacitance change is associated with the flexible circuit.

4. The device of claim 1, wherein the second conductive trace (234; 334) is disposed on both the first and the second substrate and the first substrate (220; 320) comprises a sensor panel having the sensor and portions of the first and second conductive traces disposed thereon, wherein the non-touch capacitance change is associated with the sensor panel.

5. The device of claim 1, wherein the second conductive trace (334) is disposed on both the first and the second substrate and the first substrate (320) comprises a sensor panel having the sensor, portions of the first and second conductive traces, and a conductive element (328) disposed thereon,
the conductive element (328) measures a non-touch capacitance change associated with the first substrate (320), and the second conductive trace (334) is coupled to the conductive element for transmitting a reference capacitance measurement from the conductive element so as to compensate for the non-touch capacitance change associated with the first substrate during transmission of the capacitance measurement,
wherein the non-touch capacitance change is associated with the sensor.

6. The device of claim 1, wherein the second conductive trace (234; 334) is disposed on both the first and the second substrate and the first substrate comprises a sensor panel having the sensor and portions of the first and second conductive traces disposed thereon, and
the second substrate (230; 330) comprises a flexible circuit having remaining portions of the first and second conductive traces disposed thereon,
wherein the non-touch capacitance change is associated with the sensor panel and the flexible circuit.

7. The device of claim 1, wherein the second conductive (134; 234; 334; 434) trace has a shorter length than the first conductive trace (126, 132; 226, 232; 326, 332; 426, 432) and is proximate to at least a portion of the first conductive trace on the second substrate.

8. The device of claim 1 incorporated into at least one of a mobile telephone, a digital media player, or a personal computer.

9. A method comprising:

measuring a touch at a touch sensing device (100; 200; 300; 400) using a sensor (122a, 122b; 222a, 222b; 322a, 322b; 422a, 422b) and a conductive trace, the touch measurement comprising a first capacitance of a touch region (120; 220; 320; 420) of the device, the first capacitance indicative of the touch at the touch region, wherein the first capacitance is measured using a first conductive trace (126, 132; 226, 232; 326, 332; 426, 432); measuring a second capacitance of a transmitting region (130; 230; 330; 430) of the device coupled to the touch region (120; 220; 320; 420),

wherein the second capacitance is measured using a reference conductive trace (134; 234; 334; 434) disposed on both the touch region and the transmitting region or the transmitting region, decoupled from the sensor (122a, 122b; 222a, 222b; 322a, 322b; 422a, 422b), parallel and proximate to the first conductive trace (126, 132; 226, 232; 326, 332; 426, 432);
the second capacitance indicative of an environmental change of both the touch region (120; 220; 320; 420) and the transmitting region (130; 230; 330; 430), in case the reference conductive trace is disposed on both the touch region and the transmitting region, or of the transmitting region (130; 230; 330; 430), in case the reference conductive trace is disposed on the transmitting region; and
adjusting the touch measurement based on the second capacitance measurement to compensate the touch measurement for the environmental change of at least one of the touch region or the transmitting region and the first conductive trace.

**10.** The method of claim 9, wherein adjusting the touch measurement comprises:

calculating a change in capacitance in the touch region (120; 220; 320; 420) based on the touch measurement and a capacitance in the touch region prior to the environmental change;

calculating a change in capacitance in the transmitting region (130; 230; 330; 430) based on the second capacitance measurements and a capacitance in the transmitting region prior to the environmental change; and

subtracting the calculated changes in the touch region (120; 220; 320; 420and the transmitting region (130; 230; 330; 430) from the touch measurement to compensate the touch measurement for the environmental change.

**11.** The method of claim 9, wherein adjusting the touch measurement comprises:

determining a ratio between the second capacitance measurement and a capacitance in the transmitting region (130; 230; 330; 430) prior to the environmental change; and

applying the determined ratio to a capacitance in the touch region (120; 220; 320; 420) prior to the environmental change to compensate the touch measurement for the environmental change at the device.

**12.** The method of claim 9, wherein the environmental change includes at least one of a temperature change, a humidity change, and a pressure change.

**Patentansprüche**

**1.** Berührungserkennende Vorrichtung (100; 200; 300; 400), aufweisend:

zumindest einen kapazitiven Sensor (122a, 122b; 222a, 222b; 322a, 322b; 422a, 422b), der auf einem ersten Substrat (120; 220; 320; 420) angeordnet ist, zum Erkennen einer Berührung an dem Sensor;

eine erste Leiterbahn (126, 132; 226, 232; 326, 332; 426, 432), die auf dem ersten Substrat (120; 220; 320; 420) und auf einem zweiten Substrat (230; 230; 330; 430) angeordnet ist und an den Sensor gekoppelt ist, zur Übertragung einer Berührungskapazitätsmessung, die die Berührung angibt;

eine zweite Leiterbahn (134; 234; 334; 434), die auf dem ersten und dem zweiten Substrat oder auf dem zweiten Substrat angeordnet ist, entkoppelt von dem Sensor, die auf dem ersten und dem zweiten Substrat oder auf dem zweiten Substrat (230; 230; 330; 430) parasitär mit der ersten Leiterbahn koppelt, und parallel und in der Nähe hierzu ist,

die zweite Leiterbahn (134; 234; 334; 434) zur Übertragung einer Referenzkapazitätsmessung, die eine Kapazitätsänderung einer Nicht-Berührung angibt, um so während einer Übertragung der Kapazitätsmessung die Kapazitätsänderung der Nicht-Berührung auszugleichen,

wobei die Kapazitätsänderung der Nicht-Berührung mit der ersten Leiterbahn (126, 132; 226, 232; 326, 332; 426, 432) und dem ersten Substrat (120; 220; 320; 420) oder dem zweiten Substrat (230; 230; 330; 430) assoziiert ist.

**2.** Vorrichtung nach Anspruch 1, weiterhin aufweisend zumindest eine dritte Leiterbahn, die auf dem zweiten Substrat (230; 230; 330; 430) angeordnet ist, entkoppelt von dem Sensor, und parallel und in der Nähe zu der ersten Leiterbahn auf dem zweiten Substrat (230; 230; 330; 430), die dritte Leiterbahn zum Übertragen einer anderen Referenzkapazitätsmessung, die eine weitere Kapazitätsänderung einer Nicht-Berührung angibt, um so die weitere Kapazitätsänderung der Nicht-Berührung während einer Übertragung der Berührungskapazitätsmessung auszugleichen, wobei die zweite Leiterbahn (134; 234; 334; 434) in der Mitte des zweiten Substrats (230; 230; 330; 430) platziert ist, und die dritte Leiterbahn an einer Kante des zweiten Substrats (230; 230; 330; 430) platziert ist.

**3.** Vorrichtung nach Anspruch 1, wobei das zweite Substrat (230; 230; 330; 430) eine flexible Schaltung aufweist, die die erste (132; 232; 332; 432) und die zweite Leiterbahn (134; 234; 334; 434) darauf angeordnet aufweist, wobei die Kapazitätsänderung der Nicht-Berührung mit der flexiblen Schaltung assoziiert ist.

**4.** Vorrichtung nach Anspruch 1, wobei die zweite Leiterbahn (234; 334) sowohl auf dem ersten und dem zweiten Substrat angeordnet ist, und das erste Substrat (220; 320) ein Sensorpanel aufweist, das den Sensor und Teile der ersten und zweiten Leiterbahnen darauf angeordnet aufweist, wobei die Kapazitätsänderung der Nicht-Berührung mit dem Sensorpanel assoziiert ist.

**5.** Vorrichtung nach Anspruch 1, wobei die zweite Leiterbahn (334) sowohl auf dem ersten wie auch auf dem zweiten Substrat angeordnet ist, und das erste Substrat (320) ein Sensorpanel aufweist, das den Sensor, Teile der ersten und zweiten Leiterbahn und ein leitfähiges Element (328) darauf angeordnet aufweist,
wobei das leitfähige Element (328) eine Kapazitätsänderung einer Nicht-Berührung misst, die mit dem ersten Substrat (320) assoziiert ist, und
die zweite Leiterbahn (334) mit dem leitfähigen Element gekoppelt ist, zur Übertragung einer Referenzkapazitätsmessung von dem leitfähigen Element, um so die Kapazitätsänderung der Nicht-Berührung, die mit dem ersten Substrat assoziiert ist, während einer Übertragung der Kapazitätsmessung auszugleichen,
wobei die Kapazitätsänderung der Nicht-Berührung mit dem Sensor assoziiert ist.

**6.** Vorrichtung nach Anspruch 1, wobei die zweite Leiterbahn (234; 334) sowohl auf dem ersten als auch auf dem zweiten Substrat angeordnet ist, und das erste Substrat ein Sensorpanel aufweist, das den Sensor und Teile der ersten und zweiten Leiterbahn hierauf angeordnet aufweist, und
das zweite Substrat (230; 330) eine flexible Schaltung aufweist, die restliche Teile der ersten und zweiten Leiterbahn hierauf angeordnet aufweist,
wobei die Kapazitätsänderung der Nicht-Berührung mit dem Sensorpanel und der flexiblen Schaltung assoziiert ist.

**7.** Vorrichtung nach Anspruch 1, wobei die zweite Leiterbahn (134; 234; 334; 434) eine kürzere Länge als die erste Leiterbahn (126, 132; 226, 232; 326, 332; 426, 432) aufweist, und sich in der Nähe von zumindest einem Teil der ersten Leiterbahn auf dem zweiten Substrat befindet.

**8.** Vorrichtung nach Anspruch 1, integriert in ein Mobiltelefon, einen digitalen Mediaplayer oder einen Personal-Computer.

**9.** Verfahren umfassend:

Messen einer Berührung an einer berührungserkennenden Vorrichtung (100; 200; 300; 400) unter Verwendung eines Sensors (122a, 122b; 222a, 222b; 322a, 322b; 422a, 422b) und einer Leiterbahn, wobei die Berührungsmessung eine erste Kapazität einer Berührungsregion (120; 220; 320; 420) der Vorrichtung aufweist, wobei die erste Kapazität die Berührung an der Berührungsregion angibt, und wobei die erste Kapazität unter Verwendung einer ersten Leiterbahn (126, 132; 226, 232; 326, 332; 426, 432) gemessen wird,
Messen einer zweiten Kapazität einer Übertragungsregion (130; 230; 330; 430) der Vorrichtung, die mit der Berührungsregion (120; 220; 320; 420) gekoppelt ist,

wobei die zweite Kapazität unter Verwendung einer Referenzleiterbahn (134; 234; 334; 434) gemessen wird, die sowohl auf der Berührungsregion als auch der Übertragungsregion oder der Übertragungsregion angeordnet ist, entkoppelt von dem Sensor (122a, 122b; 222a, 222b; 322a, 322b; 422a, 422b), parallel zu und in der Nähe der ersten Leiterbahn (126, 132; 226, 232; 326, 332; 426, 432);
wobei die zweite Kapazität eine Umgebungsänderung von sowohl der Berührungsregion (120; 220; 320; 420) und der Übertragungsregion (130; 230; 330; 430) angibt, für den Fall, dass die Referenzleiterbahn sowohl auf der Berührungsregion und der Übertragungsregion angeordnet ist, oder von der Übertragungsregion (130; 230; 330; 430) angibt, für den Fall, dass die Referenzleiterbahn auf der Übertragungsregion angeordnet ist; und
Anpassen der Berührungsmessung, basierend auf der zweiten Kapazitätsmessung, um die Berührungsmessung hinsichtlich der Umgebungsänderung der Berührungsregion oder der Berührungsregion und der ersten Leiterbahn auszugleichen.

**10.** Verfahren nach Anspruch 9, wobei das Anpassen der Berührungsmessung umfasst:

Berechnen einer Änderung der Kapazität in der Berührungsregion (120; 220; 320; 420), basierend auf der Berührungsmessung und einer Kapazität in der Berührungsregion, vor der Umgebungsänderung;
Berechnen einer Änderung der Kapazität in der Übertragungsregion (130; 230; 330; 430), basierend auf der zweiten Kapazitätsmessung und einer Kapazität in der Übertragungsregion, vor der Umgebungsänderung; und
Subtrahieren der berechneten Änderungen der Berührungsregion (120; 220; 320; 420) und der Übertragungsregion (130; 230; 330; 430) von der Berührungsmessung, um die Berührungsmessung hinsichtlich der Umgebungsänderung auszugleichen.

**11.** Verfahren nach Anspruch 9, wobei das Anpassen der Berührungsmessung umfasst:

Bestimmen eines Verhältnisses zwischen der zweiten Kapazitätsmessung und einer Kapazität in der Übertragungsregion (130; 230; 330; 430), vor der Umgebungsänderung; und

Anwenden des bestimmten Verhältnisses auf eine Kapazität in der Berührungsregion (120; 220; 320; 420), vor der Umgebungsänderung, um die Berührungsmessung hinsichtlich der Umgebungsänderung an der Vorrichtung auszugleichen.

**12.** Verfahren nach Anspruch 9, wobei die Umgebungsänderung eine Temperaturänderung, eine Luftfeuchtigkeitsänderung oder eine Druckveränderung enthält.

## Revendications

**1.** Dispositif de détection tactile (100 ; 200 ; 300 ; 400) comprenant :

au moins un capteur capacitif (122a, 122b ; 222a, 222b ; 322a, 322b ; 422a, 422b) disposé sur un premier substrate (120 ; 220 ; 320 ; 420) pour détecter un toucher au niveau du capteur ;
une première piste conductrice (126, 132 ; 226, 232 ; 326, 332 ; 426, 432) disposée sur le premier substrat (120 ; 220 ; 320 ; 420) et un deuxième substrat (230 ; 230 ; 330 ; 430) et couplée au capteur pour transmettre une mesure de capacité de toucher indicative du toucher ;
une deuxième piste conductrice (134 ; 234 ; 334 ; 434) disposée à la fois sur le premier et le deuxième substrat ou sur le deuxième substrat, découplée par rapport au capteur, se couplant de manière parasitaire et parallèle à et à proximité de la première piste conductrice à la fois sur le premier et le deuxième substrat ou sur le deuxième substrat (230 ; 230 ; 330 ; 430),

la deuxième piste conductrice (134 ; 234 ; 334 ; 434) étant adaptée pour transmettre une mesure de capacité de référence indicative d'un changement de capacité de non toucher de manière à compenser le changement de capacité de non toucher durant la transmission de la mesure de capacité,
le changement de capacité de non toucher étant associé à au moins un du premier substrat (120 ; 220 ; 320 ; 420) ou du deuxième substrat (230 ; 230 ; 330 ; 430) et de la première piste conductrice (126,132 ; 226, 232 ; 326, 332 ; 426, 432).

**2.** Dispositif selon la revendication 1, comprenant en outre au moins une troisième piste conductrice disposée sur le deuxième substrat (230 ; 230 ; 330 ; 430), découplée par rapport au capteur et parallèle à et à proximité de la première piste conductrice sur le deuxième substrat (230 ; 230 ; 330 ; 430), la troisième piste conductrice étant adaptée pour transmettre une autre mesure de capacité de référence indicative d'un autre changement de capacité de non toucher de manière à compenser l'autre changement de capacité de non toucher durant la transmission de la mesure de capacité de toucher, dans lequel la deuxième piste conductrice (134 ; 234 ; 334 ; 434) est placée au milieu du deuxième substrat (230 ; 230 ; 330 ; 430) et la troisième piste conductrice est placée au niveau d'un bord du deuxième substrat (230 ; 230 ; 330 ; 430).

**3.** Dispositif selon la revendication 1, dans lequel le deuxième substrat (230 ; 230 ; 330 ; 430) comprend un circuit flexible ayant les première (132 ; 232 ; 332 ; 432) et deuxième pistes conductrices (134 ; 234 ; 334 ; 434) disposées dessus, dans lequel le changement de capacité de non toucher est associé au circuit flexible.

**4.** Dispositif selon la revendication 1, dans lequel la deuxième piste conductrice (234 ; 334) est disposée à la fois sur le premier et le deuxième substrat et le premier substrat (220 ; 320) comprend un panneau de capteur avec le capteur et des portions des première et deuxième pistes conductrices disposés dessus, dans lequel le changement de capacité de non toucher est associé au panneau de capteur.

**5.** Dispositif selon la revendication 1, dans lequel la deuxième piste conductrice (334) est disposée à la fois sur le premier et le deuxième substrat et le premier substrat (320) comprend un panneau de capteur avec le capteur, des portions des première et deuxième pistes conductrices et un élément conducteur (328) disposés dessus, l'élément conducteur (328) mesure un changement de capacité de non toucher associé premier substrat (320), et
la deuxième piste conductrice (334) est couplée à l'élément conducteur pour transmettre une mesure de capacité de référence à partir de l'élément conducteur de manière à compenser le changement de capacité de non toucher associé au premier substrat durant la transmission de la mesure de capacité,
dans lequel le changement de capacité de non toucher est associé au capteur.

**6.** Dispositif selon la revendication 1, dans lequel la deuxième piste conductrice (234 ; 334) est disposée à la fois sur le premier et le deuxième substrat et le premier substrat comprend un panneau de capteur avec le capteur et des portions des première et deuxième pistes conductrices disposés dessus, et
le deuxième substrat (230 ; 330) comprend un circuit flexible ayant des portions restantes des première et deuxième pistes conductrices disposées dessus,
dans lequel le changement de capacité de non toucher est associé au panneau de capteur et au circuit flexible.

**7.** Dispositif selon la revendication 1, dans lequel la deuxième piste conductrice (134 ; 234 ; 334 ; 434) a une longueur inférieure à la première piste conductrice (126, 132 ; 226, 232 ; 326, 332 ; 426, 432) et est à proximité d'au moins une portion de la première piste conductrice sur le deuxième substrat.

**8.** Dispositif selon la revendication 1 incorporé dans au moins un téléphone mobile, un lecteur multimédia numérique ou un ordinateur personnel.

**9.** Procédé comprenant :

la mesure d'un toucher au niveau d'un dispositif de détection tactile (100 ; 200 ; 300 ; 400) en utilisant un capteur (122a, 122b; 222a, 222b ; 322a, 322b ; 422a, 422b) et une piste conductrice, la mesure de toucher comprenant une première capacité d'une région tactile (120 ; 220 ; 320 ; 420) du dispositif, la première capacité étant indicative du toucher au niveau de la région tactile, dans lequel la première capacité est mesurée en utilisant une première piste conductrice (126, 32 ; 226, 232 ; 326, 332 ; 426, 432) ;
la mesure d'une deuxième capacité d'une région de transmission (130 ; 230 ; 330 ; 430) du dispositif couplée à la région tactile (120 ; 220 ; 320 ; 420),

dans lequel la deuxième capacité est mesurée en utilisant une piste conductrice de référence (134 ; 234 ; 334 ; 434) disposée à la fois sur la région tactile et la région de transmission ou sur la région de transmission, découplée par rapport au capteur (122a, 122b ; 222a, 222b ; 322a, 322b ; 422a, 422b), parallèle à et à proximité de la première piste conductrice (126, 132 ; 226, 232 ; 326, 332 ; 426, 432) ;
la deuxième capacité étant indicative d'un changement environnemental à la fois de la région tactile (120 ; 220 ; 320 ; 420) et de la région de transmission (130 ; 230 ; 330 ; 430), dans le cas où la piste conductrice de référence est disposée à la fois sur la région tactile et la région de transmission ou sur la région de transmission (130 ; 230 ; 330 ; 430), dans le cas où la piste conductrice de référence est disposée sur la région de transmission ; et
le réglage de la mesure de toucher sur la base de la deuxième mesure de capacité pour compenser la mesure de toucher pour le changement environnemental d'au moins une de la région tactile ou de la région de transmission et de la première piste conductrice.

**10.** Procédé selon la revendication 9, dans lequel le réglage de la mesure de toucher comprend :

le calcul d'un changement de capacité dans la région tactile (120 ; 220 ; 320 ; 420) sur la base de la mesure de toucher et d'une capacité dans la région tactile avant le changement environnemental ;
le calcul d'un changement de capacité dans la région de transmission (130 ; 230 ; 330 ; 430) sur la base des deuxièmes mesures de capacité et d'une capacité dans la région de transmission avant le changement environnemental ; et
la soustraction des changements calculés dans la région tactile (120 ; 220 ; 320 ; 420) et dans la région de transmission (130 ; 230 ; 330 ; 430) à partir de la mesure de toucher pour compenser la mesure de toucher pour le changement environnemental.

**11.** Procédé selon la revendication 9, dans lequel le réglage de la mesure de toucher comprend :

la détermination d'un rapport entre la deuxième mesure de capacité et d'une capacité dans la région de transmission (130 ; 230 ; 330 ; 430) avant le changement environnemental ; et
l'application du rapport déterminé à une capacité dans la région tactile (120 ; 220 ; 320 ; 420) avant le changement environnemental pour compenser la mesure de toucher pour le changement environnemental au niveau du dispositif.

**12.** Procédé selon la revendication 9, dans lequel le changement environnemental comprend au moins un parmi une variation de température, une variation d'humidité et une variation de pression.

122-a
TOUCH
SENSOR

120
TOUCH
SENSOR
PANEL

126
SENSOR
TRACE

122-b
TOUCH
SENSOR

100

132
CONDUCTIVE
TRACE

TOUCH
CONTROLLER

140

134
REFERENCE
TRACE

130
FLEXIBLE
CIRCUIT

FIG. 1

FIG. 2

**FIG. 3**

400

422-a
TOUCH
SENSOR

420
TOUCH
SENSOR
PANEL

426
SENSOR
TRACE

422-b
TOUCH
SENSOR

432
CONDUCTIVE
TRACE

TOUCH
CONTROLLER

440

434
REFERENCE
TRACE

430
FLEXIBLE
CIRCUIT

FIG. 4

START

MEASURE CAPACITANCE
ASSOCIATED WITH TOUCH AND
ENVIRONMENTAL CHANGES — 510

MEASURE CAPACITANCE
ASSOCIATED WITH
ENVIRONMENTAL CHANGE — 520

ADJUST FIRST MEASUREMENT
BASED ON SECOND
MEASUREMENT TO COMPENSATE — 530
FOR ENVIRONMENTAL CHANGE

STOP

FIG.5

EP 2 413 224 B1

FIG.6

20

MOBILE
TELEPHONE
700

TOUCH
SENSOR
PANEL

DISPLAY
DEVICE
736

724

FIG. 7

MEDIA
PLAYER
800

TOUCH
SENSOR PANEL

DISPLAY
DEVICE
836

824

FIG. 8

PERSONAL
COMPUTER
900

DISPLAY
936

TRACKPAD
924

FIG. 9

21

**EP 2 413 224 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008947764 A1